# EUROPÄISCHE PATENTANMELDUNG

(11) **EP 0 655 401 A2**
(43) Veröffentlichungstag der Anmeldung: **31.05.1995**
(21) Anmeldenummer: 94117649.7
(22) Anmeldetag: 09.11.1994
(51) Int. Cl.: B65G 47/91, B65G 49/02, H05K 13/00

(54) **Verfahren zum Umsetzen von plattenförmigen Gegenständen, insbes. Leiterplatten, und Vorrichtung zur Durchführung des Verfahrens**

(30) Priorität: 23.11.1993 DE 4339813
(71) Anmelder: METZKA GmbH, D-90596 Schwanstetten (DE)
(72) Erfinder:
(74) Vertreter: LOUIS, PÖHLAU, LOHRENTZ & SEGETH

(57) **Zusammenfassung**

Es wird ein Verfahren und eine Vorrichtung zum Umsetzen von Gegenständen (14), insbes. Leiterplatten, von einer durch eine Lagereinrichtung (12) bestimmten Horizontalebene in eine durch ein Traggestell (18) bestimmte vertikale Endposition beschrieben. Zu diesem Zweck ist eine Greifeinrichtung (16) vorgesehen, die Saugköpfe (22) aufweist. Eine erste Antriebseinrichtung (30) dient zum Anheben der Greifeinrichtung (16) parallel zur Horizontalebene. Eine zweite Antriebseinrichtung (34) ist zum Verschwenken der Greifeinrichtung (16) und somit des mindestens einen Gegenstandes (14) um eine horizontale Schwenkachse (26) vorgesehen. Dabei wird der mindestens eine Gegenstand (14) über die Vertikalebene hinaus verschwenkt. Der über die vertikale Position hinausverschwenkte Gegenstand (14) wird mit Hilfe der ersten Antriebseinrichtung (30) dann in horizontaler Richtung zum Traggestell (18) bewegt. Anschließend erfolgt mit Hilfe einer dritten Antriebseinrichtung (32) eine Verschwenkung des über die Vertikallage hinaus verschwenkten Gegenstandes (14) in die Vertikallage, in welcher der mindestens eine Gegenstand (14) dann zwischen mindestens einer unteren Klemmeinrichtung (42) und mindestens einer oberen Klemmeinrichtung (44) des Traggestelles (18) festgeklemmt und elektrisch leitend kontaktiert wird.

## Beschreibung

Die Erfindung betrifft ein Verfahren zum Umsetzen von plattenförmigen Gegenständen, insbes. Leiterplatten, von einer durch eine Lagereinrichtung bestimmten Horizontalebene in eine durch ein Traggestell bestimmte vertikale Endposition, sowie eine Vorrichtung zur Durchführung des Verfahrens.

Ein solches Verfahren und eine Vorrichtung zur Durchführung dieses Verfahrens sind aus der DE 37 03 542 A1 bekannt. Dort ist eine Hebevorrichtung zum Anheben der plattenförmigen Gegenstände, insbes. Leiterplatten, vorgesehen, die mit Saugköpfen versehen sein kann. Die Hebeeinrichtung dient dort außerdem zur linearen Verschiebung der jeweiligen angehobenen Leiterplatte zu einer ersten Transporteinrichtung, die vorzugsweise mit einem Transportband versehen ist. Mit der ersten Transporteinrichtung fluchtet eine zweite Transporteinrichtung, die ebenfalls mit einem Transportband ausgebildet sein kann. Die zweite Transporteinrichtung ist um eine horizontale Schwenkachse in eine vertikale Stellung verschwenkbar, wobei Saugnäpfe an der zweiten Transporteinrichtung dafür sorgen, daß die an der zweiten Transporteinrichtung befindlichen Leiterplatten während des Schwenkvorgangs an der zweiten Transporteinrichtung fixiert bleiben. In der vertikalen Position werden die Leiterplatten dann von der zweiten Transporteinrichtung an einen geeigneten Greifer übergeben, der ebenfalls mit Saugköpfen versehen ist. Mit Hilfe des zuletzt erwähnten Greifers werden die Leiterplatten dann an ein vertikales Traggestell übergeben. Die Abnahme der behandelten plattenförmigen Gegenstände, insbes. Leiterplatten, vom Traggestell zu einer Ablage erfolgt in entsprechender Weise jedoch in umgekehrter Reihenfolge.

In der DE 41 18 846 C1 ist ausgeführt, daß die besagten ebenflächigen Gegenstände, insbes. Leiterplatten, in ihrem den eigentlichen Nutzen aufweisenden Bereich weder von Hand noch durch Transportmittel wie Sauger o.dgl. berührt werden sollen, da diese Berührung an den Berührungsflächen zu Fehlern und damit zu Produktionsausfällen führen kann. Aus diesem Grunde schlägt die zuletzt erwähnte Druckschrift ein Verfahren zum Transportieren und Anbringen von chemisch zu behandelndem, insbes. zu galvanisierendem, plattenförmigem Gut, insbes. von Leiterplatten, zu und an Warenträgern, die Klammern zum lösbaren Halt der Platten aufweisen, sowie zur Abnahme der behandelten Platten vom Warenträger und zu deren Abtransport vor, wobei die in senkrechter Lage angelieferten Platten oder die in Sonderfällen in einer anderen, nicht senkrechten Anlieferungslage antransportierten Platten in eine senkrechte Ausgangslage bewegt und aus dieser Ausgangslage in senkrechter Position durch maschinelle Erfassung lediglich an ihren Galvanorändern vereinzelt und nacheinander in einem definierten Abstand unter einen Warenträger transportiert werden. Diese definierten Abstände sind auf die Abstände und Position der Klammern des Warenträgers abgestimmt. Anschließend erfolgt ein Anheben der Platten und deren Erfassen durch die Klammern des Warenträgers ebenfalls nur am Galvanorand. Nach der Behandlung der Platten in den Behandlungsstationen einer chemischen Anlage erfolgen im Prinzip die vorstehend erläuterten Maßnahmen jedoch im umgekehrten Funktionsablauf durch zunächst Lösen der Platten vom Warenträger, Absenken der Platten und Weitertransport zu einer Ablage.

Der Erfindung liegt die Aufgabe zugrunde, ein Verfahren der eingangs genannten Art und eine Vorrichtung zur Durchführung dieses Verfahrens zu schaffen, wobei es mit konstruktiv einfachen Mitteln zeitsparend möglich ist, plattenförmige Gegenstände, insbes. Leiterplatten, von einer Lagereinrichtung zu einem Traggestell - und umgekehrt - umzusetzen, wobei der Produktionsausschuß auf ein Minimum reduziert ist.

Diese Aufgabe wird verfahrensgemäß durch die Gesamtheit der Verfahrensschritte gelöst:
- Greifen mindestens eines umzusetzenden, horizontal positionierten Gegenstandes,
- Anheben des mindestens einen gegriffenen Gegenstandes parallel zur Horizontalebene in einer ersten Richtung, die zur Horizontalebene des Gegenstands senkrecht orientiert ist,
- Verschwenken des mindestens einen angehobenen horizontalen Gegenstandes um eine zur ersten Richtung senkrechte horizontale Schwenkachse in einer ersten Drehrichtung in eine über die Vertikalebene hinausgehende Schräglage,
- Verschieben des mindestens einen in der Schräglage befindlichen Gegenstandes in einer zur Horizontalebene parallelen und zur ersten Drehrichtung senkrechten zweiten Richtung zum Traggestell, bis der mindestens eine Gegenstand mit seinem unteren Rand an einer geöffneten unteren Klemmeinrichtung des Traggestells anliegt,
- Zurückschwenken des mindestens einen Gegenstandes um die horizontale Schwenkachse im zur ersten Drehrichtung entgegengesetzten Drehsinn in die vertikale Endposition bis der mindestens eine Gegenstand mit seinem oberen Rand an einer geöffneten oberen Klemmeinrichtung des Traggestells anliegt, und
- Schließen der oberen und der unteren Klemmeinrichtung des Traggestells zur elektrischen Kontaktierung des mindestens einen Gegenstandes an dem Traggestell.

Durch das erfindungsgemäße Verschwenken des mindestens einen Gegenstandes in der ersten Drehrichtung in eine über die Vertikalebene hinausgehende Schräglage wird erreicht, daß der besagte mindestens eine Gegenstand in bezug auf die Vertikalebene des Traggestells eine Projektionsfläche aufweist, die kleiner ist als die tatsächliche Fläche des mindestens einen Gegenstandes, was bedeutet, daß der schräggestellte mindestens eine Gegenstand in einfacher Weise zwischen der unteren und der oberen Klemmeinrichtung des Traggestells positioniert und danach zuverlässig festgeklemmt werden kann. Als vorteilhaft hat es sich hierbei erwiesen, wenn der mindestens eine umzusetzende Gegenstand mittels einer eine Anzahl Saugköpfe aufweisenden Greifeinrichtung gegriffen und von der Lagereinrichtung zum Transportgestell umgesetzt wird. Dabei kommen zweckmäßigerweise Saugköpfe zur Anwendung, die relativ klein sind, so daß sie sich am mindestens einen umzusetzenden Gegenstand, insbes. Leiterplatte bzw. dessen Nutzen, nicht störend bemerkbar machen.

Zweckmäßig ist es, wenn der mindestens eine Gegenstand mittels einer ersten Antriebseinrichtung in der ersten Richtung angehoben, anschließend mit einer zweiten Antriebseinrichtung in der ersten Drehrichtung verschwenkt, danach mittels der ersten Antriebseinrichtung in der zweiten Richtung verschoben und dann mittels einer dritten Antriebseinrichtung in die vertikale Endposition zurückgeschwenkt wird. Das Anheben des Gegenstandes in der ersten Richtung, d.h. Parallel zur Horizontalebene der Lagereinrichtung wird durchgeführt, damit der horizontal ausgerichtete Gegenstand beim Verschwenken in der ersten Drehrichtung nicht mit der Lagereinrichtung kollidiert. Nach diesem Anheben in der ersten Richtung kann das Verschwenken um die horizontale Schwenkachse und das Verschieben des entsprechenden Gegenstandes in der zweiten Richtung zeitlich aufeinanderfolgend oder gleichzeitig erfolgen.

Die untere Klemmeinrichtung kann beim erfindungsgemäßen Verfahren mittels einer vierten Antriebseinrichtung und die obere Klemmeinrichtung kann mittels einer fünften Antriebseinrichtung betätigt werden. Bei allen diesen Antriebseinrichtungen handelt es sich zweckmäßigerweise um Kolben-Zylinder-Einheiten, die hydraulisch oder vorzugsweise pneumatisch betätigt werden.

Das erfindungsgemäße Verfahren kann manuell gesteuert oder zweckmäßigerweise automatisch durchgeführt werden, wenn die Antriebseinrichtungen mittels einer einen programmierbaren Computer aufweisenden Steuereinrichtung betätigt werden. Ein solches Verfahren ist mit geringstem Personalaufwand realisierbar.

Die der Erfindung zugrundeliegende Aufgabe wird erfindungsgemäß gelöst durch
- eine Greifeinrichtung, die eine Anzahl Saugköpfe zum Festhalten mindestens eines Gegenstandes aufweist,
- eine erste Antriebseinrichtung zum Anheben der Greifeinrichtung parallel zur Horizontalebene,
- eine zweite Antriebseinrichtung zum Verschwenken der ersten Antriebseinrichtung und somit des mindestens einen angehobenen horizontalen Gegenstandes um eine ortsfest vorgesehene, horizontal orientierte Schwenkachse in einer ersten Drehrichtung,
- eine dritte Antriebseinrichtung, die von der ersten Antriebseinrichtung beabstandet mit der Greifeinrichtung verbunden und dazu vorgesehen ist, die Greifeinrichtung in der zur ersten Drehrichtung entgegengesetzten zweiten Drehrichtung um die ortsfeste Schwenkachse zu verschwenken,
- eine vierte Antriebseinrichtung zum Betätigen von am Traggestell vorgesehenen unteren Klemmeinrichtungen,
- eine fünfte Antriebseinrichtung zum Betätigen von am Traggestell vorgesehenen oberen Klemmeinrichtungen, und
- eine einen programmierbaren Computer aufweisende Steuereinrichtung, die mit den fünf Antriebseinrichtungen zusammengeschaltet ist. Bei der erfindungsgemäßen Vorrichtung hat es sich als zweckmäßig erwiesen, wenn die Greifeinrichtung ein formstabiles ebenes Grundteil aufweist, von dem die Saugköpfe in die gleiche Richtung wegstehen. Dieses Grundteil kann als Platte oder als Rahmen ausgebildet sein. Die Saugköpfe weisen - wie bereits erwähnt worden ist - zweckmäßigerweise nur kleine Abmessungen auf, so daß sie sich bei geeigneter Dimensionierung des Grundteils und bei entsprechender Anordnung am Grundteil am sog. Nutzen des jeweiligen plattenförmigen Gegenstandes nicht störend bemerkbar machen.

Die Schwenkachse kann an einer Konsole der erfindungsgemäßen Vorrichtung vorgesehen sein, und an der Schwenkachse kann ein Schwenkteil gelagert sein, an dem die erste, die zweite und die dritte Antriebseinrichtung angeschlossen sind. Das besagte Schwenkteil kann platten- oder rahmenförmig oder beliebig anders ausgebildet sein. Es muß nur ausreichend formstabil sein, um die erste, die zweite und die dritte Antriebseinrichtung daran geeignet festlegen zu können. Andererseits soll das Schwenkteil nur ein relativ kleines Gesamtgewicht besitzen, damit seine Verschwenkung um die zugehörige Schwenkachse mit geringstmöglichem Kraft- und Energieaufwand durchführbar ist.

Die fünf Antriebseinrichtungen der erfindungsgemäßen Vorrichtung sind jeweils vorzugsweise als Kolben-Zylinder-Einrichtungen ausgebildet, die hydraulisch oder vorzugsweise pneumatisch betätigt werden. Eine pneumatische Betätigung weist hierbei im Vergleich zu einer hydraulischen Betätigung den Vorteil auf, daß keine Hydraulikflüssigkeit zur Anwendung gelangt, welche bspw. eine Galvanikanlage, bei der die erfindungsgemäße Vorrichtung zur Anwendung gelangt, beeinträchtigen könnte.

Bei der erfindungsgemäßen Vorrichtung hat es sich als zweckmäßig erwiesen, wenn jede der oberen Klemmeinrichtungen zwei zueinander mindestens annähernd parallele und miteinander schwenkbeweglich verbundene Klemmteile aufweist, die am einen Endabschnitt mit einander zugewandten Kontaktelementen für mindestens einen zugehörigen, zu kontaktierenden Gegenstand versehen sind, wobei die Verbindungs- bzw. Schwenkachse auf einer Seite der entsprechenden Klemmeinrichtung außerhalb der Klemmteile in einem mittleren Abschnitt der Klemmeinrichtung vorgesehen ist, zwischen den beiden Klemmteilen eine Federeinrichtung wirksam ist, und die zugehörige fünfte Antriebseinrichtung dem von den Kontaktelementen entfernten zweiten Endabschnitt eines der Klemmteile zugeordnet ist. Durch eine solche Ausbildung der oberen Klemmeinrichtungen mit einer außenseitigen Verbindungs- bzw. Schwenkachse ergibt sich bei einer Betätigung der fünften Antriebseinrichtung ein Öffnen der zugehörigen oberen Klemmeinrichtung in der Weise, daß das betätigte Klemmteil nicht nur aufschwenkt, sondern hierbei quasi gleichzeitig auch in Längsrichtung des entsprechenden Klemmteiles derartig verstellt wird, daß der festzuklemmende Gegenstand problemlos zwischen die beiden Klemmteile bzw. die zugehörigen Endabschnitte der Klemmteile eingebracht werden kann.

Bei der erfindungsgemäßen Vorrichtung kommen zweckmäßigerweise untere Klemmeinrichtungen zur Anwendung, wie sie in der DE 93 09 768 U1 der Anmelderin offenbart sind.

Weitere Einzelheiten, Merkmale und Vorteile des erfindungsgemäßen Verfahrens bzw. der erfindungsgemäßen Vorrichtung zur Durchführung des Verfahrens ergeben sich aus der nachfolgenden Beschreibung eines in der Zeichnung dargestellten Ausführungsbeispieles der erfindungsgemäßen Vorrichtung. Es zeigen:
- Fig. 1: abschnittweise die Vorrichtung in einer Seitenansicht,
- Fig. 2: in einem größeren Maßstab den Ausschnitt der erfindungsgemäßen Vorrichtung, welcher die Greifeinrichtung mit einem Gegenstand in der über die Vertikalebene hinausgehenden Schräglage zeigt,
- Fig. 3: weiter vergrößert eine obere Klemmeinrichtung in einer Seitenansicht, und
- Fig. 4: in einem der Fig. 3 ähnlichen Maßstab eine Seitenansicht einer unteren Klemmeinrichtung.

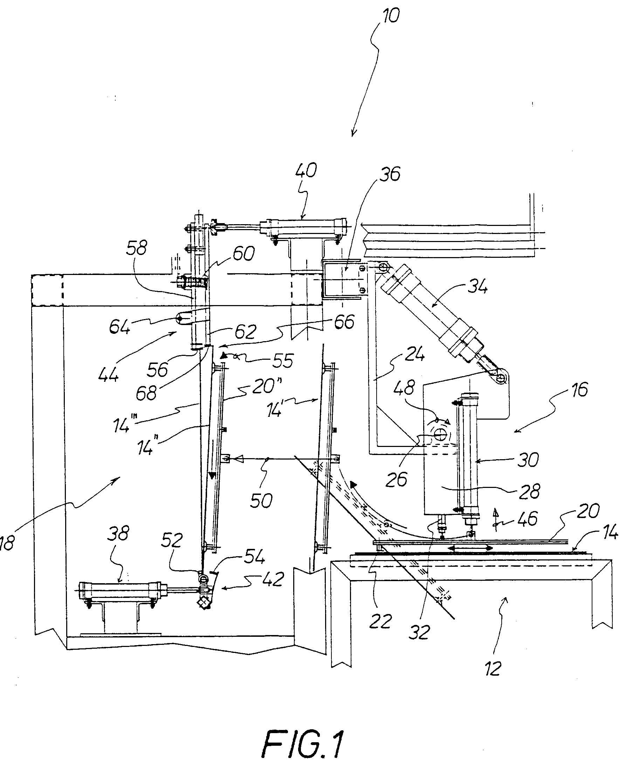

Fig. 1 zeigt in einer Seitenansicht abschnittweise eine Vorrichtung 10 mit einer abschnittweise gezeichneten Lagereinrichtung 12, auf welcher hintereinander plattenförmige Gegenstände 14, insbes. Leiterplatten, angeordnet sind. Die Gegenstände 14 befinden sich in einer Horizontalebene. Eine Greifeinrichtung 16 ist dazu vorgesehen, mindestens einen der Gegenstände 14 von der Lagereinrichtung 12 zu einem Traggestell 18 umzusetzen. Die Greifeinrichtung 16 weist ein formstabiles ebenes Grundteil 20 auf, von dem in die gleiche Richtung Saugköpfe 22 wegstehen, von welchen in Fig. 1 in der Ausgangsstellung des Grundteiles 20 nur einer sichtbar ist.

Die Greifeinrichtung 16 weist eine Konsole 24 mit einer horizontalen Schwenkachse 26 auf, an welcher ein Schwenkteil 28 gelagert ist. Am Schwenkteil 28 ist eine erste Antriebseinrichtung 30 und eine dritte Antriebseinrichtung 32 vorgesehen, bei welchen es sich zweckmäßigerweise um Kolben-Zylinder-Einrichtungen handelt, die pneumatisch angetrieben werden. Die erste und die dritte Antriebseinrichtung 30, 32 sind voneinander beabstandet und mit dem Grundteil 20 der Greifeinrichtung 16 verbunden. Zwischen der Konsole 24 und dem Schwenkteil 28 der Greifeinrichtung 16 ist eine zweite Antriebseinrichtung 34 angeordnet, die wie die erste und die dritte Antriebseinrichtung 30, 32 zweckmäßigerweise als Kolben-Zylinder-Einrichtung ausgebildet ist, die vorzugsweise pneumatisch angetrieben wird.

Die Konsole 24 ist mit dem Traggestell 18 mittels eines Konstruktionsteiles 36 verbunden bzw. in bezug auf das Traggestell 18 verstellbar. Am Traggestell 18 ist eine vierte Antriebseinrichtung 38 und eine fünfte Antriebseinrichtung 40 angeordnet, wobei die vierte Antriebseinrichtung 38 zur Betätigung von am Traggestell 18 vorgesehenen unteren Klemmeinrichtungen 42 und die fünfte Antriebseinrichtung 40 zur Betätigung oberer Klemmeinrichtungen 44 vorgesehen ist. Die vierte und die fünfte Antriebseinrichtung 38, 40 sind wie die erste, die zweite und die dritte Antriebseinrichtung 30, 34 und 32 vorzugsweise als Kolben-Zylinder-Einrichtungen ausgebildet, die zweckmäßigerweise pneumatisch angetrieben werden.

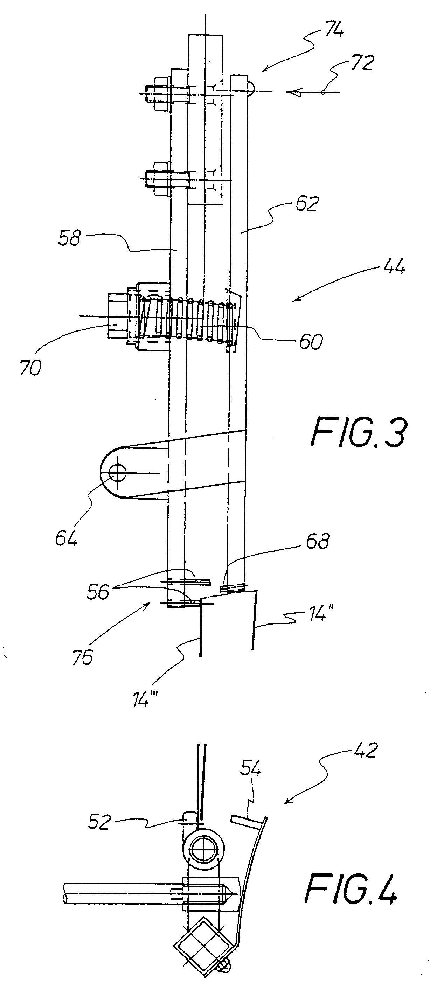

Eine untere Klemmeinrichtung 42 zeigt Fig. 4 und ist in der DE-U 93 09 768 U1 der Anmelderin offenbart, so daß es nicht erforderlich ist, hier detailliert auf die Ausbildung der besagten unteren Klemmeinrichtung 42 einzugehen. Eine obere Klemmeinrichtung 44 wird weiter unten noch in Verbindung mit Fig. 3 beschrieben.

Erfindungsgemäß wird zum Umsetzen mindestens eines plattenförmigen Gegenstandes 14 derartig vorgegangen, daß der besagte mindestens eine plattenförmige Gegenstand 14 mit den Saugköpfen 22 am Grundteil 20 passend festgelegt wird. Dann wird die erste Antriebseinrichtung 30 betätigt, so daß der entsprechende Gegenstand 14 in vertikaler Richtung angehoben wird, was durch den Pfeil 46 angedeutet ist. Dann wird die zweite Antriebseinrichtung 34 betätigt, so daß das Schwenkteil 28 in dem durch den bogenförmigen Pfeil 48 verdeutlichten Uhrzeigersinn um die ortsfeste Schwenkachse 26 verschwenkt wird. Das bedeutet eine Verschwenkung des entsprechenden Gegenstandes 14 in die durch die Bezugsziffer 14' verdeutlichte Schräglage über die vertikale Lage hinaus. Anschließend wird der entsprechende Gegenstand 14' durch geeignete Betätigung der ersten Antriebseinrichtung 30 in horizontaler Richtung verstellt, was durch den Pfeil 50 angedeutet ist, bis der entsprechende Gegenstand bzw. das den besagten Gegenstand haltende Grundteil 20 sich in der durch die Bezugsziffer 20'' bezeichneten Lage befindet. In dieser Lage liegt der entsprechende Gegenstand 14'' mit seinem unteren Rand an der mindestens einen unteren geöffneten Klemmeinrichtung 42, d.h. an der ortsfesten Kontakteinrichtung 52 der unteren Klemmeinrichtung 42 an. Die bewegliche Kontakteinrichtung 54 der unteren Klemmeinrichtung 42 weist in der geöffneten Stellung von der ortsfesten Kontakteinrichtung 52 einen entsprechenden Abstand auf. Die Betätigung der beweglichen Kontakteinrichtung 54 der unteren Klemmeinrichtung 42 erfolgt mit der vierten Antriebseinrichtung 38. Sobald der Gegenstand 14'' an der ortsfesten Kontakteinrichtung 52 der unteren Klemmeinrichtung 42 anliegt, erfolgt eine Betätigung der dritten Antriebseinrichtung 32 derartig, daß der Gegenstand 14'' von der Schräglage in die vertikale Position 14''' im entgegengesetzten Uhrzeigersinn verschwenkt wird, was durch den bogenförmigen Pfeil 55 angedeutet ist. Durch geeignete Ausbildung der entsprechenden oberen Klemmeinrichtung 44 wird diese Verschwenkung des entsprechenden Gegenstandes von der Position 14'' zur vertikalen Position 14''' durch die zugehörige obere Klemmeinrichtung 44 nicht behindert. Bis der jeweilige Gegenstand in die vertikale Position 14''' geschwenkt wird, befindet sich die mindestens eine zugehörige obere Klemmeinrichtung 44 mit Hilfe der fünften Antriebseinrichtung 40 in der geöffneten Stellung. Sobald der Gegenstand 14''' an Kontaktelementen 56 eines ortsfesten Klemmteiles 58 (sh. auch Fig. 3) anliegt, wird die fünfte Antriebseinrichtung 40 von der aktiven Öffnungsstellung der oberen Klemmeinrichtung 44 in eine inaktive Position zurückgestellt, so daß sich eine in der aktiven Öffnungs- bzw. Betriebsstellung der fünften Antriebseinrichtung 40 mechanisch gespannte Federeinrichtung 60, die zwischen dem ortsfesten Klemmteil 58 und einem beweglichen Klemmteil 62 vorgesehen ist, wieder entspannen kann. Diese mechanische Entspannung der Federeinrichtung 60 bewirkt eine Verschwenkung des beweglichen Klemmteiles 62 um eine zugehörige Verbindungs- bzw. Schwenkachse 64 derart, daß der obere Rand 66 des Gegenstandes 14''' zwischen Kontaktelementen 56 des ortsfesten Klemmteiles 58 und Kontaktelementen 68 des beweglichen Klemmteiles 62 eingeklemmt und elektrisch zuverlässig kontaktiert wird.

Oben wurde das Umsetzen plattenförmiger Gegenstände 14 von einer Lagereinrichtung 12 zu einem Traggestell 18 beschrieben. Es versteht sich, daß es mit der erfindungsgemäßen Vorrichtung 10 ebenso möglich ist, Gegenstände 14, insbes. Leiterplatten, vom Traggestell 18 zu einer Lagereinrichtung 14 zurück umzusetzen.

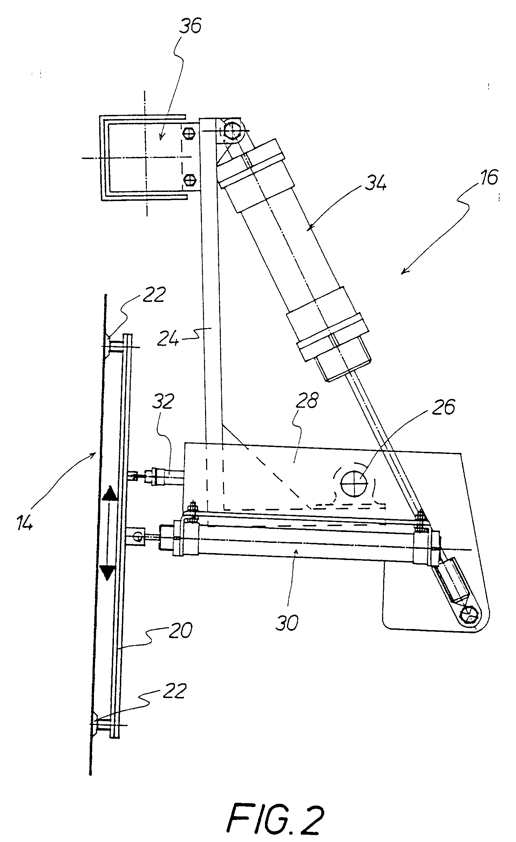

Fig. 2 verdeutlicht in einem größeren Maßstab die Greifeinrichtung 16 mit der Konsole 24, die am Konstruktionsteil 36 ortsfest oder entlang des Konstruktionsteiles 36 linear beweglich vorgesehen sein kann. An der Konsole 24 ist das Schwenkteil 28 um die Schwenkachse 26 verschwenkbar gelagert, wobei in dieser Zeichnungsfigur das Schwenkteil 28 in die über die Vertikalebene hinausgehende Schräglage gezeichnet ist. Zu diesem Zweck ist die zweite Antriebseinrichtung 34 entsprechend betätigt, d.h. verlängert. Mit der Bezugsziffer 30 ist auch in dieser Zeichnungsfigur die erste Antriebseinrichtung bezeichnet, die zwischen dem Schwenkteil 28 und dem Grundteil 20 der Greifeinrichtung 16 vorgesehen ist. Am Grundteil 20 greift von der ersten Antriebseinrichtung 30 beabstandet die dritte Antriebseinrichtung 32 an, die zur ersten Antriebseinrichtung 30 parallel vorgesehen ist, d.h. mit ihrem einen Ende am Grundteil 20 und mit ihrem zweiten Ende am Schwenkteil 28 festgelegt ist. Vom Grundteil 20 stehen in dieselbe Richtung Saugknöpfe 22 weg, die zum Festlegen mindestens eines Gegenstandes 14 vorgesehen sind.

Fig. 3 zeigt eine der oberen Klemmeinrichtungen 44 der Vorrichtung 10 gemäß Fig. 1 in einem vergrößerten Maßstab. Die/jede obere Klemmeinrichtung 44 weist ein ortsfestes Klemmteil 58 und mindestens annähernd parallel zu diesem ein bewegliches Klemmteil 62 auf. Zwischen dem ortsfesten und dem beweglichen Klemmteil 58, 62 ist eine Federeinrichtung 60 vorgesehen, die bspw. als Schraubendruckfeder ausgebildet ist. Die Vorspannung der Federeinrichtung 60 ist bspw. mittels einer geeigneten Einrichtung 70 wunschgemäß einstellbar. Die beiden Klemmteile 58 und 62 sind miteinander mittels einer Verbindungs- bzw. Schwenkachse 64 schwenkbeweglich verbunden. Die Verbindungs- bzw. Schwenkachse 64 ist seitlich neben den beiden Klemmteilen 58 und 62 vorgesehen, so daß eine Betätigung des beweglichen Klemmteiles 62, die in Fig. 3 durch den Pfeil 72 angedeutet ist, und die an dem Endabschnitt 74 wirksam ist, der dem Endabschnitt 76 gegenüberliegt, an welchem das ortsfeste Klemmteil 58 mit Kontaktelementen 56 und das bewegliche Klemmteil 62 mit zugehörigen Kontaktelementen 68 ausgebildet ist, eine Verschwenkung des beweglichen Klemmteiles 62 um die Verbindungs- bzw. Schwenkachse 64 derartig ergibt, daß der entsprechende mindestens eine über die Vertikalebene hinaus verschwenkte Gegenstand 14'' unbehindert in die durch die Bezugsziffer 14''' bezeichnete Vertikallage im entgegengesetzten Uhrzeigersinn verschwenkt werden kann.

Fig. 4 verdeutlicht eine der unteren Klemmeinrichtungen 42 mit ihrer ortsfesten Kontakteinrichtung 52 und mit ihrer federnd beweglichen Kontakteinrichtung 54, wobei die federnd bewegliche Kontakteinrichtung 54 mittels einer (in Fig. 4 nicht gezeichneten) vierten Antriebseinrichtung 38 betätigbar ist, wie sie in Fig. 1 gezeichnet ist. Bezüglich der unteren Klemmeinrichtung 42 wird auf das bereits weiter oben erwähnte DE 93 09 768 U1 der Anmelderin Bezug genommen.

## Patentansprüche

1. Verfahren zum Umsetzen von plattenförmigen Gegenständen (14), insbes. Leiterplatten, von einer durch eine Lagereinrichtung (12) bestimmten Horizontalebene in eine durch ein Traggestell (18) bestimmte vertikale Endposition,
**gekennzeichnet durch**
die Gesamtheit der Verfahrensschritte
- Greifen mindestens eines umzusetzenden Gegenstandes (14),
- Anheben des mindestens einen gegriffenen Gegenstandes
(14) parallel zur Horizontalebene in einer ersten Raumrichtung (46), die zur Horizontalebene des Gegenstandes senkrecht orientiert ist,
- Verschwenken des mindestens einen angehobenen horizontalen Gegenstandes (14) um eine zur ersten Richtung (46) senkrechte, horizontale Schwenkachse (26) in einer ersten Drehrichtung (48) in eine über die Vertikalebene hinausgehende Schräglage,
- Verschieben des mindestens einen in der Schräglage befindlichen Gegenstandes (14) in einer zur Horizontalebene parallelen und zur ersten Drehrichtung (48) senkrechten zweiten Richtung (50) zum Traggestell (18), bis der mindestens eine Gegenstand (14) mit seinem unteren Rand an einer geöffneten unteren Klemmeinrichtung (42) des Traggestells (18) anliegt,
- Zurückschwenken des mindestens einen Gegenstandes (14) um die horizontale Schwenkachse (26) im zur ersten Drehrichtung (48) entgegengesetzten Drehsinn (55) in die vertikale Endposition bis der mindestens eine Gegenstand (14) mit seinem oberen Rand an einer geöffneten oberen Klemmeinrichtung (44) des Traggestells (18) anliegt, und
- Schließen der oberen und der unteren Klemmeinrichtung
(44, 42) des Traggestells (18) zur elektrischen Kontaktierung des mindestens einen Gegenstandes (14)
an dem Traggestell (18).

2. Verfahren nach Anspruch 1,
**dadurch gekennzeichnet,**
daß der mindestens eine umzusetzende Gegenstand (14) mittels einer eine Anzahl Saugköpfe (22) aufweisenden Greifeinrichtung (16) gegriffen und von der Lagereinrichtung (12) zum Traggestell (18) umgesetzt wird.

3. Verfahren nach Anspruch 1,
**dadurch gekennzeichnet**,
daß der mindestens eine Gegenstand (14) mittels einer ersten Antriebseinrichtung (30) in der ersten Richtung (46) angehoben, anschließend mittels einer zweiten Antriebseinrichtung (34) in der ersten Drehrichtung (48) verschwenkt, danach mittels der ersten Antriebseinrichtung (30) in der zweiten Richtung (50) verschoben und dann mittels einer dritten Antriebseinrichtung (32) in die vertikale Endposition zurückverschwenkt wird.

4. Verfahren nach Anspruch 1,
**dadurch gekennzeichnet**,
daß die untere Klemmeinrichtung (42) mittels einer vierten Antriebseinrichtung (38) und die obere Klemmeinrichtung (44) mittels einer fünften Antriebseinrichtung (40) betätigt werden.

5. Verfahren nach Anspruch 3 und 4,
**dadurch gekennzeichnet,**
daß die Antriebseinrichtungen (30, 32, 34, 38, 40) mittels einer einen Mikroprozessor aufweisenden Steuereinrichtung betätigt werden.

6. Vorrichtung zur Durchführung des Verfahrens nach einem der Ansprüche 1 bis 5 zum Umsetzen von plattenförmigen Gegenständen (14), insbes. Leiterplatten, von einer eine Horizontalebene bestimmenden Lagereinrichtung (12) zu einem eine mindestens annähernd senkrechte Endposition bestimmenden Traggestell (18),
**gekennzeichnet durch**
eine Greifeinrichtung (16), die eine Anzahl Saugköpfe (22) zum Festhalten mindestens eines Gegenstandes (14) aufweist,
eine erste Antriebseinrichtung (30) zum Anheben der Greifeinrichtung (16) parallel zur Horizontalebene,
eine zweite Antriebseinrichtung (34) zum Verschwenken der Greifeinrichtung (16) und somit des mindestens einen angehobenen horizontalen Gegenstandes (14) um eine ortsfest vorgesehene horizontal orientierte Schwenkachse (26) in einer ersten Drehrichtung (48),
eine dritte Antriebseinrichtung (32), die von der ersten Antriebseinrichtung (30) beabstandet mit der Greifeinrichtung (16) verbunden und dazu vorgesehen ist, die Greifeinrichtung (16) in der zur ersten Drehrichtung (48) entgegengesetzten zweiten Drehrichtung (55) um die ortsfeste Schwenkachse (26) zu verschwenken,
eine vierte Antriebseinrichtung (38) zum Betätigen von am Traggestell (18) vorgesehenen unteren Klemmeinrichtungen (42),
eine fünfte Antriebseinrichtung (40) zum Betätigen von am Traggestell (18) vorgesehenen oberen Klemmeinrichtungen (44), und
eine einen Mikroprozessor aufweisende Steuereinrichtung, die mit den fünf Antriebseinrichtungen (30, 32, 34, 38, 40) zusammengeschaltet ist.

7. Vorrichtung nach Anspruch 6,
**dadurch gekennzeichnet,**
daß die Greifeinrichtung (16) ein formstabiles ebenes Grundteil (20) aufweist, von dem die Saugköpfe (22) in die gleiche Richtung wegstehen.

8. Vorrichtung nach Anspruch 6,
**dadurch gekennzeichnet**,
daß die Schwenkachse (26) an einer Konsole (24) vorgesehen ist, und daß an der Schwenkachse (26) ein Schwenkteil (28) gelagert ist, an welches die erste, die zweite und die dritte Antriebseinrichtung (30, 34, 32) angeschlossen sind.

9. Vorrichtung nach Anspruch 6,
**dadurch gekennzeichnet,**
daß die fünf Antriebseinrichtungen (30, 32, 34, 38, 40) jeweils als Kolben-Zylinder-Einrichtung ausgebildet ist.

10. Vorrichtung nach Anspruch 6,
**dadurch gekennzeichnet,**
daß jede der oberen Klemmeinrichtungen (44) zwei zueinander mindestens annähernd parallele und miteinander schwenkbeweglich verbundene Klemmteile (58, 62) aufweist, die am einen Endabschnitt (76) mit einander zugewandten Kontaktelementen (56, 68) für einen zugehörigen, zu kontaktierenden Gegenstand (14) versehen sind, wobei die Verbindungs- bzw. Schwenkachse (64) auf einer Seite der entsprechenden Klemmeinrichtung (44) außerhalb der Klemmteile (58, 62) in einem mittleren Abschnitt der Klemmeinrichtung (44) vorgesehen ist, zwischen den beiden Klemmteilen (58, 62) eine Federeinrichtung (60) angeordnet ist, und die zugehörige fünfte Antriebseinrichtung (40) dem von den Kontaktelementen (56, 68) entfernten zweiten Endabschnitt (74) eines der Klemmteile (58, 62) zugeordnet ist.
